# EUROPÄISCHE PATENTANMELDUNG

(11) **EP 1 220 327 A2**
(43) Veröffentlichungstag der Anmeldung: **03.07.2002**
(21) Anmeldenummer: 01130435.9
(22) Anmeldetag: 20.12.2001
(51) Int. Cl.: H01L 31/048, E04D 13/18

(54) **Lichtelement für eine Lichtdachkonstruktion**

(30) Priorität: 02.01.2001 DE 20100043 U; 07.03.2001 DE 10110936
(71) Anmelder: Schmidt-Tudl, Arnold, 97877 Wertheim (DE)
(72) Erfinder: Schmidt-Tudl, Arnold, 97877 Wertheim (DE)
(74) Vertreter: Schulz, Rütger, Dr. Dipl.-Phys.

(57) **Zusammenfassung**

Die Erfindung betrifft ein plattenförmiges Element (1) für eine Lichtdachkonstruktion, bestehend aus zwei Profilplatten (1a, 1b). Damit das plattenförmige Element (1) sich für die Gewinnung von Energie aus einer Sonnenbestrahlung eignet, ist zwischen den Profilplatten (1a, 1b) eine Trägerfolie (4) angeordnet, in der nebeneinanderliegende Solarzellen (3), insbesondere kristalline Solarzellen, eingebettet sind, wobei die Trägerfolie (4) mit ihrer Ober- und Unterseite an den Profilplatten (1a, 1b) anliegt.

## Beschreibung

Die Erfindung bezieht sich auf ein Lichtelement für eine Lichtdachkonstruktion.

Ein Lichtelement ist ein plattenförmiges Bauteil, das bei etwa horizontaler (Flachdach) oder schräger (Schrägdach oder Spitzdach) oder in nach oben gewölbter Form (gewölbtes Dach) allein oder bei Anordnung mehrerer nebeneinander angeordneter, vorzugsweise gleicher Lichtelemente eine Lichtdachkonstruktion bildet. Die Dachfläche bzw. Lichtdachkonstruktion kann somit aus nur einem oder mehreren nebeneinander angeordneten Lichtelementen bestehen, die an sogenannten Stoßfugen aneinanderliegen oder einen geringen abgedichteten Abstand (Spalt) voneinander aufweisen. Zur Abstützung eines Lichtelements oder mehrerer in wenigstens einer Reihe nebeneinander angeordneter Lichtelemente bedarf es zumindest zweier Träger, die an einander gegenüberliegenden Rändern des oder der Lichtelemente angeordnet sind, wobei das oder die Lichtelemente den zwischen den Trägern vorhandenen Abstand freitragend überbrücken. Das bzw. die Lichtelemente sind dabei von einer so großen Festigkeit, dass sie diese Überbrückungsfunktion unter Berücksichtigung üblicher Dachlasten, z. B. Eigengewicht und Schneelast, erfüllen. Dabei soll das wenigstens eine Lichtelement von leichter und materialsparender Bauweise sein, um die Lichtdachkonstruktion möglichst leicht auszubilden und die Material- bzw. Herstellungskosten gering zu halten.

Der Erfindung liegt die Aufgabe zugrunde, ein Lichtelement der vorliegenden Art so auszugestalten, dass es bei Gewährleistung einer einfachen und kostengünstigen Bauweise sich für die Gewinnung von Energie aus seiner Sonnenbestrahlung eignet. Außerdem ist eine Bauweise anzustreben, bei der auch bei einer gewölbten Form des Lichtelements die Bruchgefahr vermieden oder vermindert ist.

Diese Aufgabe wird durch die Merkmale des Anspruchs 1 gelöst. Vorteilhafte Weiterbildungen der Erfindung sind in den Unteransprüchen beschrieben.

Das erfindungsgemäße Lichtelement weist Solarzellen, insbesondere ebene, scheibenförmige kristalline Solarzellen auf, die die angestrebte Energiegewinnung gewährleisten. Die Solarzellen befinden sich im Lichtelement und sind dadurch geschützt angeordnet vor Beschädigungen durch mechanische Einwirkung und Korrosion. Die einfache Bauweise ist dadurch gewährleistet, dass das Lichtelement aus zwei sandwichartig aufeinanderliegenden, vorzugsweise gleichen, Hohlprofilplatten besteht, zwischen denen die in eine Trägerfolie eingebetteten Solarzellen angeordnet sind, wobei die vorzugsweise hohlen Profilplatten mit der Trägerfolie fest verbunden, z.B. verschweißt oder verklebt sind und das Lichtelement somit eine feste Baueinheit bildet. Die Anschlüsse zu den Solarzellen sind von innen und außen zugänglich, so dass in einer auf dem Dach verlegten Anordnung des Lichtelements eine elektrische Verbindung mit einem Stromkreislauf realisiert werden kann.

Die Einbettung der Solarzellen in die Trägerfolie führt dazu, dass die Solarzellen quer zu ihrer Plattenerstreckung eng begrenzt und dadurch in dieser Querrichtung gestützt sind. Hierdurch ist die Bruchgefahr für die Solarzellen vermieden, zumindest vermindert, wenn sie in einem gewölbten Lichtelement eingesetzt werden und aufgrund der Wölbung der Profilplatten einer Biegespannung ausgesetzt sind. Dies gilt für ebene und insbesondere für gewölbte Lichtelemente.

Die Trägerfolie bildet mit den Solarzellen eine Solarzellenmatte, die die Anordnung der Solarzellen zwischen den Hohlprofilplatten wesentlich vereinfacht. Es braucht lediglich die Matte zwischen den Hohlprofilplatten positioniert zu werden, an der sich die Solarzellen in der gewünschten Anordnung befinden. Die Positionierung der Solarzellen wird bei der unabhängigen Fertigung der Matten durchgeführt. Dies kann an getrennten Orten und unterschiedlichen Zeiten erfolgen, wobei eine Vielzahl Matten als Vorrat vorgefertigt und am Fertigungsort für die Lichtelemente bereitgestellt werden können.

Bei der Einbettung der Solarzellen in die Trägerfolie sind die Solarzellen auch im Vorfertigungsstadium durch die Trägerfolie allseitig geschützt. Die Trägerfolie kann aus zwei Teilfolien bestehen, die sandwichartig aufeinander liegen und wenigstens in den Randbereichen fest miteinander verbunden sind, z. B. durch Schweißen, Siegeln oder Kleben.

Nachfolgend werden die Erfindung und weitere durch sie erzielbare Vorteile anhand von bevorzugten Ausgestaltungen eines Ausführungsbeispiels näher erläutert.

Es zeigen
Fig. 1 ein erfindungsgemäßes plattenförmiges Element, insbesondere Lichtelement für eine Lichtdachkonstruktion im vertikalen Schnitt I-I in Figur 2;
Fig. 2 das Lichtelement in der Draufsicht;
Fig. 3 den Randbereich x in Figur 1 in vergrößerter Darstellung;
Fig. 4 eine Lichtdachkonstruktion für ein gewölbtes Dach mit zylinderabschnittförmig gewölbten plattenförmigen Elementen.

Das in seiner Gesamtheit mit 1 bezeichnete Lichtelement ist von flacher bzw. plattenförmiger Bauform, wobei es in der Draufsicht gesehen eine rechteckige oder quadratische Form aufweist.

Das Lichtelement 1 besteht aus zwei übereinander angeordneten, vorzugsweise hohlen Profilplatten, 1a, 1b und einer dazwischen angeordneten Solarzellenmatte 2, die eine Vielzahl Solarzellen 3 auf ihren Flächenbereich verteilt angeordnet aufweist und zwischen den Profilplatten 1a, 1b gelegt ist. Das Element ist gewölbt mit einem Krümmungsradius von beispielsweise einem Meter. Die Solarzellenmatte 2 besteht aus einer Trägerfolie und den darin eingebetteten Solarzellen 3. Die Breite B der Solarzellen beträgt beispielsweise 10 cm, so dass der Krümmungsradius der Elemente mehr als das achtfache dieser Breite beträgt. Die Profilplatten 1a, 1b sind mit der Trägerfolie 4 sandwichartig und fest verbunden. Hierdurch sind die Solarzellen 3 von mechanischer Beschädigung und Korrosion geschützt im Lichtelement 1 angeordnet. Es ist von Vorteil, die Solarzellen 3 jeweils in einem Abstand 1c vom Rand der Profilplatten 1a, 1b anzuordnen, so dass sie auch im Bereich der Schmalseiten des Lichtelements 1 geschützt angeordnet sind. Im Bereich des Randabstands 1c können zwischen der Trägerfolie 4 und den Profilplatten 1a, 1b die Dickenverjüngung der Trägerfolie 4 ausgleichende Füllschichten 4d vorgesehen sein.

Eine besonders vorteilhafte Ausgestaltung für eine Einbettung der Solarzellen 3 besteht darin, die Trägerfolie 4 aus zwei übereinander angeordneten Teilfolien 4a, 4b zu bilden, die sandwichartig übereinander angeordnet und in der vorbeschriebenen Weise mit den Profilplatten 1a, 1b verbunden sind.

Die Profilplatten 1a, 1b und die Trägerfolie 4 oder die Teilfolien 4a, 4b bestehen aus lichtdurchlässigem oder opalisierendem Material, insbesondere Kunststoff.

Die aus lichtundurchlässigem Material bestehenden Solarzellen 3 sind so geformt oder angeordnet, dass zwischen ihnen freie Bereiche 5 vorhanden sind, durch die hindurch Licht durch das Lichtelement 1 strahlen kann. Dies kann dadurch erreicht werden, dass die Solarzellen 3 in einem Abstand voneinander angeordnet sind. Beim vorliegenden Ausführungsbeispiel weisen die Solarzellen 3 eine von einer viereckigen bzw. quadratischen Form in den Eckenbereichen vorzugsweise abweichende Form auf. Hierdurch werden in den gemeinsamen Eckenbereichen der Solarzellen 3 die freien Bereiche 5 bildende Durchtrittslöcher für Licht geschaffen. Beim vorliegenden Ausführungsbeispiel weisen die Solarzellen 3 eine im wesentlichen achteckige Form auf. Aufgrund dieser Form liegen die Solarzellen 3 dann, wenn sie dicht aneinander anliegen, an geraden Randabschnitten 3a aneinander an. Die Randabschnitte können auch einen kleinen Abstand voneinander aufweisen.

Da die Solarzellenmatte 2 ein vorfertigbares Bauteil ist, kann sie unabhängig vom Lichtelement 1 in einer Vielzahl vorgefertigt, gelagert und bereitgestellt werden. Zur Herstellung der Solarzellenmatte 2 werden die Solarzellen 3 auf der unteren Teilfolie 4a geordnet aufgelegt. Dann wird die obere Teilfolie 4b aufgelegt, und die Teilfolien werden dann miteinander verbunden, z. B. veschweisst, versiegelt oder verklebt. Dies kann in einem dazu geeigneten Ofen erfolgen.

Zur Fertigstellung eines Lichtelements 1 wird die untere Profilplatte 1a am Montageort positioniert. Dann werden zunächst die Solarzellenmatte 2 und dann die Profilplatte 1b aufeinandergelegt. Die so gebildete Einheit wird dann miteinander verbunden, z. B. durch Schweißen, Siegeln oder Kleben.

Beim vorliegenden Ausführungsbeispiel sind die Profilplatten 1a, 1b durch sogenannte Doppelstegprofile gebildet, jeweils mit einer Oberwand, einer Unterwand und mehreren, diese miteinander verbindenden Stegwänden. Die Profilform gewährleistet eine Herstellung durch Strangpressen. Durch die Ausbildung in Hohlprofilform wird Material und Gewicht eingespart bei Gewährleistung eines großen Biegewiderstandsmomentes.

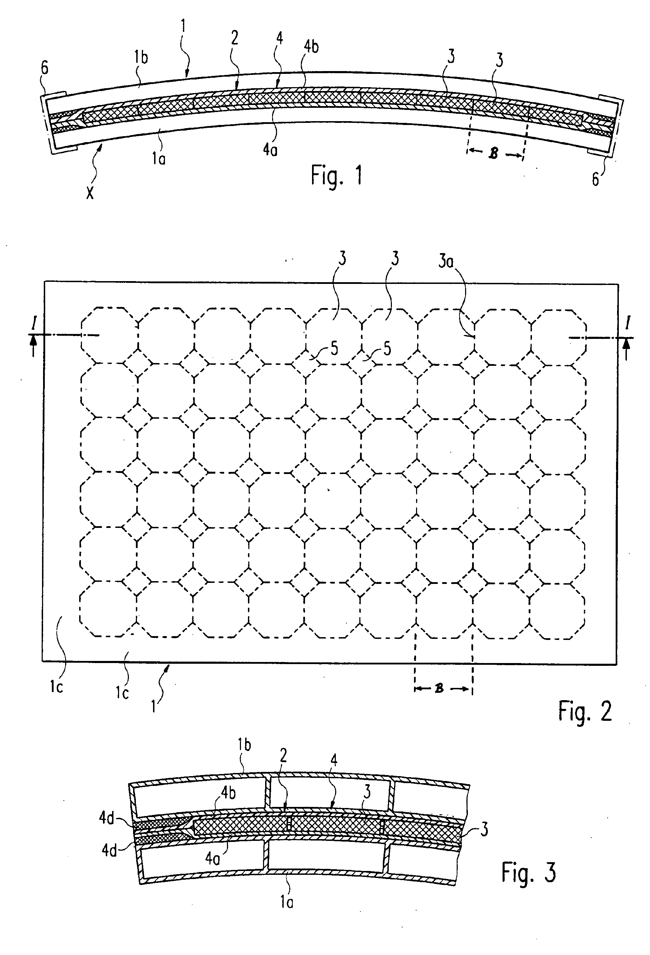

Wie Figur 1 deutlich zeigt, ist das Lichtelement 1 zylinderabschnittförmig nach oben gewölbt.

Es kann im übrigen vorteilhaft sein, das Lichtelement 1 durch einen seine schmalen Stirnseiten umgebenden Rahmen 6, z.B. aus U-Profilen, zu stabilisieren. Bei einer U-Form können die Stege des U-Profils die Ränder des Lichtelements 1 übergreifen.

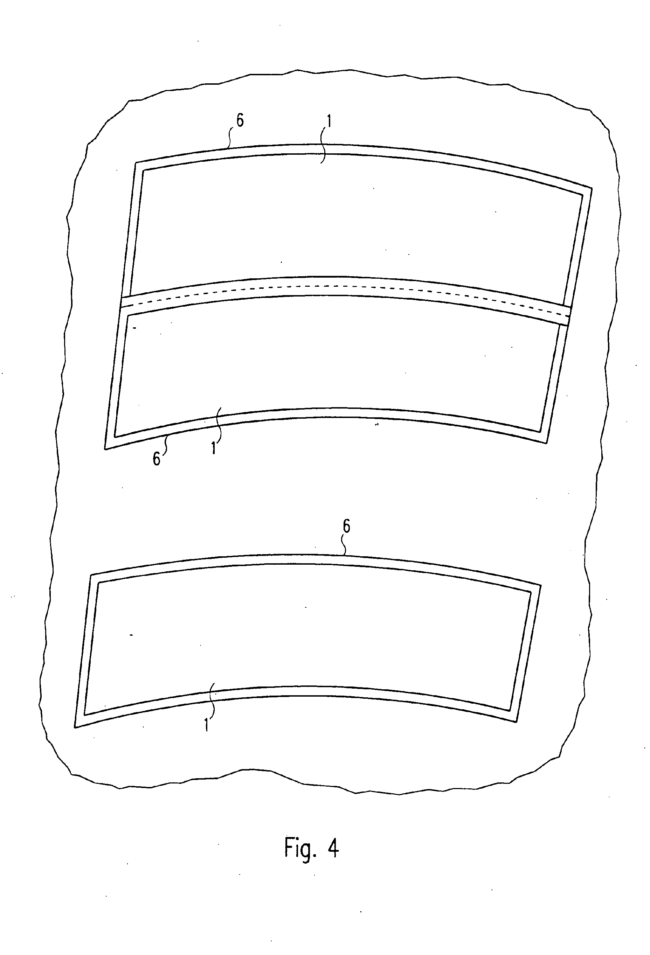

Figur 4 zeigt eine Lichtdachkonstruktion mit einem gewölbten Dach, wobei ein durch ein Lichtelement 1 und ein durch zwei nebeneinander angeordnete Lichtelemente 1 gebildetes Dachfenster vorgesehen sind.

Im Rahmen der Erfindung ist es möglich, die Solarzellen 3 ohne freie Bereiche 5 anzuordnen. Ein solches Element dient hauptsächlich der Energiegewinnung.

Die Solarzellen brauchen nicht in dem im wesentlichen gesamten Bereich des Lichtelements 1 angeordnet sein. Sie können auch in einem oder mehreren Bereichen bzw. Feldern angeordnet sein, der bzw. das kleiner ist als in Fig. 2 dargestellt.

## Patentansprüche

1. Lichtelement (1) für eine Lichtdachkonstruktion,
bestehend aus zwei Profilplatten (1a, 1b), zwischen denen eine Trägerfolie (4) angeordnet ist, in der nebeneinanderliegende Solarzellen (3), insbesondere scheibenförmige kristalline Solarzellen, eingebettet sind, wobei die Trägerfolie (4) mit ihrer Ober- und Unterseite an den Profilplatten (1a, 1b) anliegt.

2. Lichtelement nach Anspruch 1,
**dadurch gekennzeichnet,**
**dass** die Profilplatten (1a, 1b) gekrümmt sind, wobei der Krümmungsradius vorzugsweise größer als 0,5 m ist.

3. Lichtelement nach Anspruch 1 oder 2,
**dadurch gekennzeichnet,**
**dass** der Krümmungsradius wenigstens das achtfache der Breite B der Solarzellen (3) beträgt.

4. Lichtelement nach einem der Ansprüche 1 bis 3,
**dadurch gekennzeichnet,**
**dass** die Trägerfolie (4) aus zwei übereinander angeordneten Teilfolien (4a, 4b) besteht, zwischen denen die Solarzellen (3) angeordnet sind.

5. Lichtelement nach einem der Ansprüche 1 bis 4,
**dadurch gekennzeichnet,**
**dass** zwischen den Solarzellen (3) freie Bereiche (5) angeordnet sind.

6. Lichtelement nach einem der vorherigen Ansprüche,
**dadurch gekennzeichnet,**
**dass** die Solarzellen (3) eine im wesentlichen vier- oder achteckige Form aufweisen.

7. Lichtelement nach einem der vorherigen Ansprüche,
**dadurch gekennzeichnet,**
**dass** die Solarzellen (3) von den äußeren Rändern der Trägerfolie (4) bzw. der Profilplatten (1a, 1b) bzw. der Materialbahn einen Abstand aufweisen.

8. Lichtelement nach einem der vorherigen Ansprüche,
**dadurch gekennzeichnet,**
**dass** die Profilplatten (1a,1b) durch Hohlprofile, insbesondere durch Doppelstegprofile, gebildet sind.

9. Lichtelement nach einem der vorherigen Ansprüche,
**dadurch gekennzeichnet,**
**dass** die Solarzellen (3) in nur einem Teilbereich des plattenförmigen Elements (1) angeordnet sind.
